# EUROPEAN PATENT APPLICATION

(11) **EP 3 572 873 A1**
(43) Date of publication of application: **27.11.2019**
(21) Application number: 18173943.4
(22) Date of filing: 24.05.2018
(51) Int. Cl.: G03F 7/00, H01L 27/12, H05K 3/12, H05K 3/10

(54) **METHOD FOR REDUCING THE WIDTH OF STRUCTURES GENERATED BY INK DEPOSITION ON PRE-PATTERNED SUBSTRATES**

(71) Applicant: PAUL SCHERRER INSTITUT, 5232 Villigen PSI (CH)
(72) Inventor: HORVATH, Barbara, 2512 Hausen (CH); SCHIFT, Helmut, 2503 Biel (CH)
(74) Representative: Fischer, Michael

(57) **Abstract**

It is the objective of the present invention to provide a method for reducing the width of structures generated by ink deposition on pre-patterned substrates that enables the generation of fine structure in the sub-wavelength range at low cost and high throughput in order to satisfy the demand for a technology being less expensive than known lithographic processes.

This objective is achieved according to the present invention by a method for producing insulating and/or electrically conductive micro- and nano-structures, such as wires or an array thereof, on surfaces having a pre-patterned structure, comprising the steps of:
a) providing a substrate having a patterned structure of grooves and/or capillaries;
b) self-limiting filling of open grooves and/or capillaries with a functional liquid by capillary action; each wire having a width created by the shape and geometry of the open grooves and/or capillaries; said grooves and/or capillaries having dimensions that they are filled by the functional liquid which is dragged into them by capillary action;
c) said grooves and/or capillaries providing lateral confinement of the liquid enabling a separation from neighboring areas and grooves and/or capillaries;
d) said functional liquid comprising a solvent or a mixture of solvents and dispersed particles therein; said particles are significantly smaller than the open width of the grooves and/or capillaries;
e) said particles cluster together upon evaporation of the solvent resulting in structures of clustered particles, such as lines, along the grooves and/or capillaries.

## Description

The present invention relates to a method for producing insulating and/or electrically conductive micro- and nano-structures, such as wires or an array thereof, on surfaces, e.g. on surfaces of pre-patterned substrates.

High resolution lithography such as mask-based photolithography, interference lithography, parallel electron beam lithography and nanoimprint lithography have opened up the high volume manufacturing of sub-micrometer (pm) devices. Apart from shrinking line widths of electrical wires and gates on electronic chips this includes, among many other applications, sub-wavelength lines, dots and gratings for wire grid polarizers, transparent metal electrodes, patterned sapphire substrates, patterned magnetic media and photonic crystals. For some applications, however, the effort of cutting cost down asks for even simpler and more cost-effective solutions. E.g., in printed electronics on flexible substrates such as polymers and paper, gravure and inkjet printing are considered as much more inexpensive than standard and even advanced lithography, with their capability to print large areas by roll-to-roll with speeds of several meters per second.

They are additive processes which use functional materials that are either pure or composed of solvents containing pigments or particles of different materials. After solidification, e.g., by evaporation of solvent, they are either directly used (e.g., as colors) or need to be converted into their functionality by light, heat, plasma, chemical processes, etc. E.g., for achieving high conductivity, particles have to be in intimate contact or sintered together. However, the minimum resolution (wire width, but also wire distance) is typically above 20 µm, or for some high resolution processes, down to 5 or even 2 µm. This is due to several limitations, e.g., minimum ink droplet and gravure cell sizes, placement accuracy, inaccuracies during ink transfer and control of spreading on surfaces, but mostly also because single droplets have to merge and to form larger entities before they can eventually be sintered into a metal film with high conductivity.

Therefore, not only small line widths have to be achieved, but also small distances between wires, which requires low line edge roughness, accuracy of positioning and finally, high homogeneity of materials, particularly if composed of micro- and nanoparticles.

Future applications, such as flat panel displays, need thin-film transistor (TFT) with gate lengths below 5 µm, or transparent electrodes as a replacement for indium tin oxide (ITO) needs metallic gratings with sub-wavelength wire dimensions in order to enhance transparency and reduce optical scattering and diffraction effects. One is the typical fishnet structure in which long wires covering only a fraction of a surface are interconnected in a net or ladder-like manner in order to ensure conductance in longitudinal direction (the wires) and in lateral direction (interconnection between wires to avoid shorts in individual wires). Here, efforts are needed to shrink dimensions without using traditional lithography, i.e. the patterning of a resist and conversion of the resist contrast (topological or chemical) into a metal pattern by so-called pattern transfer. One possibility is to pre-pattern the substrates with specific sub-micron topography by straightforward replication techniques such as thermal or UV-assisted nanoimprint lithography and then address the surface locally with low resolution additive patterning, e.g. by inking.

It is therefore the objective of the present invention to provide a method for reducing the width of structures generated by ink deposition on pre-patterned substrates that enables the generation of fine structure in the sub-wavelength range at low cost and high throughput in order to satisfy the demand for a technology being less expensive than known lithographic processes.

This objective is achieved according to the present invention by a method for producing insulating or electrically conductive micro- and nano-structures, such as wires or an array thereof, on pre-patterned surfaces of a substrate, comprising the steps of:
a) providing a substrate having a surface topology with a patterned structure of grooves and/or capillaries;
b) self-limiting filling of open grooves or capillaries with a functional liquid by capillary action; each wire having a width created by the shape and geometry of the open grooves and/or capillaries; said grooves and/or capillaries having dimensions that they are filled by the functional liquid which is dragged into them by capillary action;
c) said grooves and/or capillaries providing lateral confinement of the liquid enabling a separation from neighboring areas and grooves and/or capillaries;
d) said functional liquid comprising a solvent or a mixture of solvents and dispersed particles therein; said particles are significantly smaller than the open width of the grooves and/or capillaries;
e) said particles cluster together upon evaporation of the solvent resulting in structures of clustered particles, such as lines, along the grooves and/or capillaries.

This method allows the generation of fine structures even in the nano-domain according to the particle load comprised in the functional liquid. The reducing of the width of structures generated by ink deposition on the pre-patterned substrates enables the generation of fine structures in the sub-wavelength range at low cost and high throughput in order to satisfy the demand for a technology being less expensive than known lithographic processes.

In the following, advantageous embodiments of the present invention are disclosed that can be applied alone or in combination:
a) a reduction of the width of the filled grooves and/or capillaries is achieved by solvent evaporation and retraction of remaining functional liquid in said grooves and/or capillaries of the pre-patterned surface of the substrate;
b) locally chemically modified substrates are provided, preferably comprising stripes with alternating surface energies, e.g. hydrophilic and hydrophobic;
c) a combination of capillary action and size reduction by solvent evaporation is applied;
d) the size reduction is supported by heating the substrate after the filling to the extent that a thermal reflow of the substrate occurs; said thermal reflow generating a surface equilibration and surface energy reduction of viscoelastic materials at temperatures where these substrate materials flow;
e) the functional liquid comprises at least one micro and/or nanoparticle loaded solvent;
f) the ratio of the particle content to the solvent content is varied over the filling step;
g) the content of the micro- and/or nano-particle load is varied over the filling step;
h) the particle load comprise one or more the following ingredients:
   - metals, such as Ag, Au, Co, Pt;
   - semiconductors, such as Si, GaN, GaAs, TiO2, ZnO, CdS;
   - insulators, such as SiO2, Si3N4, Al2O3, SiC; and
   - organic particles, such as bucky balls, polystyrene, PMMA, micelles, diamond, graphite;
i) wire structures with a multitude of materials are generated, e.g. by filling different channels with different functional liquids; and/or by filling a trench first with one functional liquid, and then, optionally after drying, with a second material;
j) the first functional liquid assumes a shape in the groove and/or the trench which allows to fill the groove and/or capillary either again with the same principle, e.g., capillary filling one material above each other, and/or by a combination, e.g.first V-groove filling, then capillary filling), preferably used for the manufacturing of transistors and/or batteries;
k) the micro- and/or nano-structures having a ratio of the micro- and/or nano-structures to the width of the grooves and/or capillaries of at least 1:2; preferably achieved by:
   - the solvent evaporation and/or the nanoparticles assembly; and/or
   - the geometry of the grooves and/or capillaries enabling the collection of material by capillary action; e.g. in a V-groove shape (as given by <100> silicon anisotropically etched in KOH), allowing the nanoparticles to segregate and agglomerate in the center of the V-groove;
l) a generated electrical micro- and nanowire having at least one dimension other than its propagation dimension being smaller than a coupled light wavelength; and/or
m) the assembled (nano-)particles are sintered together to achieve high conductivity structures, wherein the structure generated being disposed according to at least one of the following design options: array-like, ordered, regular and disordered, semi-random, random, variable period or thickness as an array of structures, such as nanowires.
n) in some cases, the effects described here can be used in closed capillaries, too. E.g., if the capillaries are manufactured in silicone (PDMS, poly dimethyl siloxane) or open microcapillaries closed by a lid made from PDMS, the distribution of the liquid in the capillaries can be enhanced (e.g. by pre-soaking the PDMS stamp with solvent), excess material equilibrated (through pressure or by soaking into the stamp) and air and solvent removed through the porous material. Therefore, the evaporation of the solvent, as necessary to convert the nanoparticle-loaded ink into a solid, becomes similar to open microfluidics.

Thus, the methods described above can be used for the generation of metallic wires from nanoparticle-based metal inks and reduction of their line width by specific surface structures using capillary filling and/or selective modification of surfaces by thermal treatment.

Preferred embodiments of the present invention are hereinafter described in more detail with reference to the attached drawings which depict in:
- Figure 1: schematically a comparison of two major methods used for the fabrication of flexible electronics; both relying on transfer of individual droplets onto surfaces which merge into a film or a confined pattern (if wires are needed);
- Figure 2: schematically the spreading of ink droplets in pre-patterned substrates;
- Figure 3: an optical micrograph of a 2 mm long double line filled with silver after filling two trenches from two sides each;
- Figure 4: schematically the process to generate self-forming metal line pattern, left side: general view, right side: magnification;
- Figure 5: SEM micrographs of a self-forming metal line pattern after spin-coating of the silver ink on dense V-grooves with a 830 nm period; the left side shows 600 nm wide wires, the right side 250 nm wide wires; and/or
- Figure 6: schematically different wire configurations that can be achieved by the application of disclosed methods.

The present invention discloses methods for generating fine structures on pre-patterned substrates that are generated by ink deposition and further process steps, such as the evaporation of the solvents comprised in the ink and/or the thermal/chemical treatment of the substrate after ink deposition. Redistribution (transport, spreading, coagulation, merging, splitting/separation) of the ink by capillary effects, thus enabling transport, direction and confinement of the ink by guiding and pinning elements before or during the drying and/or sintering process, creates lines and/or reduces the width of inked lines to the desired size. Heat treatment, enabling the transformation of the substrate, e.g. by thermal reflow, might supports the process of shrinkage and confinement while the ink nanoparticles assume their final shape and sinter together.

The present invention has opened a way to explore this by using nanoparticle loaded inks, i.e. silver nanoparticles dispersed in solvents which evaporate either directly after deposition onto substrates or after heat treatment. That results in a collapse or shrinkage of the droplet due to loss of volume of the solvent, which drags the particles nearer and eventually merges them into loosely bound agglomerate. Further heat treatment leads to contact and sintering of particles into a conductive composite. In many cases, the heat treatment should not alter the shape of the substrate, which can be usually either a pure or coated polymer film, or already contains some functional patterns or even structured coatings from previous processing steps. For the heat treatment, the applicant has also applied a thermal reflow, sometimes only restricted to specific areas, which changes a material property relevant for further processing, i.e. a reduced glass transition temperature *T_{g},* which results from a reduction in molecular weight *M_{w}* upon exposure. In the context of the line reduction presented here, it is basically a process which can take place in parallel to the drying and sintering, enabling the simultaneous evaporation of solvents, the coagulation and adjustment of contact angles according to surface energy and topography, and the vanishing of the surface structure upon reflow of the substrate.

In preferred embodiments of the present invention, the following method steps are comprises:

### A. Pre-structuring of substrates

Pre-structured polymer substrates are manufactured using nanoimprint or other molding techniques such as roll embossing, injection molding, casting, hot embossing. Other techniques, e.g. mechanical scribing, creating a defined surface topography, are suitable as well. In printed electronics the surface topography is created in a polymer layer which is either the foils or a banking/ planarization layer on top of it. Topographies typically have aspect ratio of 1 and lower, and are U-groove or V-groove shaped. Line structures are preferred for directed flow, pillar structures for pinning, mixed structures for directed but limited flow. Line arrays can vary in density but in most cases, a groove can be distinguished from the flat top surface, i.e. the land, or in case of V-grooves ridge-like undulations. Grooves can be arranged orthogonally (as it is when silicon <100> stamps are used for patterning the polymer), but also in any other lateral direction.

Silicon wafers were coated with 100 nm of LPCVD Si₃N₄. Afterwards spincoating of the negative resist, prebake 90 s @ 110°C has been followed. Photolithography with mask of 2 µm period on a SUSS MA6 Maskaligner, or using photolithography variants such as Talbot displacement photolithography (PHABLE) method, are used and a postbake of 120 s @ 110°C, are applied wet development. Dry etching of Si₃N₄ using KOH etching 20%, 80°C for about 20 to 40 min. V-groove shape, but additionally Λ-shape with preferentially sharp tips is generated. Similar gratings can be obtained from blazed optical grating. Due to replication by thermal imprint and UV-assisted imprint, V-grooves are converted into Λ-ridges and vice versa. Final replication into 2 µm thick PMMA layer (nominal moleculer weight 120k, T_{g} = 128°C) coated onto a 100 mm silicon wafer or a PET foil. Imprint for 10 min at T = 180°C and p = 10 kPa and demolding at 60°C are foreseen.

### B. Coating

The coating can be done "globally", i.e. by a wafer-level process in which an entire substrate can be coated with processes such as spincoating, dip coating (immersion) or reverse gravure coating, flexoprinting, enabling to coat entire surfaces from individual droplets which merge after spreading. Inkjet printing allows local coating of individual spots, defined areas or entire surfaces, if droplets merge into a continuous local film. In all these examples, the droplets or liquid volumes cover areas larger than the individual droplet. Particularly important is volume control, which can be done by balancing adhesion and density of the droplets. The aim is to coat ink onto surfaces which - after dewetting/removal of excess material of the top layer - fills all trenches/grooves but not the entire surface. Other techniques can be used such as in screen printing or blade wiping for removal of excess material. The so-called liquid transfer imprint lithography (LTIL) mode, allow control of coating thickness by removing part of the coated film by delaminating a cover from the wet polymer film. The aim is either that the "lands" are never coated or are de-wetted due to flow, surface energy optimization and shrinkage.

Liquid transfer can also be done by offset printing, capillary filling along grooves or capillaries, guiding by rails: generally, here the generation of thin lines is addressed which are below the typical resolution of the techniques used for inking.

The selection of the ink considers the following features:
Small particle size (<50 nm) for achieving high resolution and low line edge roughness; low aggregation of particles into clusters and low particle growth during processing which is typically achieved by additives; low curing/sintering temperature and good conductivity.

Some of these points cannot be fulfilled in some cases simultaneously. The aim is to have a multi modal particle size distribution to achieve a higher conductivity. Inks with smaller particles usually need to contain more dispersant to prevent the aggregation and subsequent particle size growth - this however may reduce the conductivity and/or may increase the sintering temperatures needed to render the ink into a conductive pattern after printing.

Suitable inks appear to be Silver nanoparticle loaded inks: from Genes'Ink, Sigma-Aldrich, Clariant, Advanced Nano Products Co., UT Dots, etc.
Silver nanoparticle dispersions in suitable solvents for low temperature processing are preferred.

### Examples:

a) Silver, dispersion 736473 from Sigma-Aldrich (Product of ANP, Inc.), nanoparticle (particle size ≤50 nm), 30-35 wt. % in triethylene glycol monomethyl ether, viscosity 10-18 mPa·s
b) Silver, dispersion S-CS01130 from Genes'Ink Smart'Ink, nanoparticle (particle size ≤50 nm), 20 ± 1% wt. % in alkane/alcohol, viscosity 13 ± 3 mPa·s
c) Silver, dispersion S-CS31506 from Genes'Ink Smart'Ink, nanoparticle (particle size ≤50 nm), 50 ± 5% wt. % in alcohol/glycol, viscosity 150 - 400 mPa·s

Further solution/thinning can be achieved in different solvents, e.g., isopropyl alcohol, 2-Methoxyethanol, ethanol, 2,2,4-trimethylpentane, decane, toluene, 2-heptane.

Depositon of ink onto surfaces by localized or delocalized inking: Delocalized inking: Droplets are disposed at the area of interest and are spreading from pads into narrow channels/grooves/capillaries, where they are dragged along sidewalls until they are starving (run out of supply);
Localized inking: droplets are spread over pre-patterned areas where they distribute homogeneously.

### Methods of coating

Inkjet printing, gravure printing, spray or spincoating are methods for coating surfaces.

Inkjet printing allows local coating or individual spots or entire surfaces, it typically requires the use of low density inks, i.e. low viscosity with low particle content. Apart from sophisticated inkjet printers allowing to achieve droplet sizes of 10 µm, also plotters with much larger droplet sizes can be used, e.g., Biospot BT-600 from BioFluidiX, able to generate droplets with 150 pL - 50 µL.

Spincoating is meant for homogeneous coating of surfaces by casting. A defined thickness is accomplished by suitable viscosity acceleration, rotation speed, and time. E.g., acceleration of 2000 rpm/min, speed 5000-8000 rpm and time of 60-420s were used. Reverse gravure is a method mainly used for the coating of large area sheets with a homogeneous film, particularly polymer and paper substrates used for roll-to-roll processes. It is derived from gravure printing, which enables to pattern surfaces by transfer of ink from a roller to a sheet from specific cavities at the roll which are filled with ink.

### Selective filling

After deposition of individual droplets onto a surface (inking), the droplets accommodate to the surface by spreading, merging, capillary filling (and surface energy optimization) and dewetting. This is controlled by surface energy (material, homogeneity) and topography (defined lines, channels, rails, holes and pillars or random roughness). Capillary filling happens along channels and in channels, i.e. in the so-called Wenzel case, where the entire surface is wetted, including trenches and transition phases. Wetting characteristics that capillary bridges and menisci can form within the channels, pulling liquid further along lines while providing liquid flow from the original droplet which serves as a reservoir.

### By capillary effects

Surfaces can be mechanically dewetted by a soft "doctor's blade" (also called "squeegee"). In case of gravure printing the flat cylinder surface is wiped clean by a soft blade, leaving recessed areas (the cells) filled with ink, while ink covering the elevated areas (top flats) is removed. Separation is mechanically but segregation can be alleviated by surface treatment, e.g. by cells as ink-receiving, while the elevated areas are ink-repelling. By dewetting of specific areas particle loaded liquids will not contaminate such surfaces and leave stains on sidewalls and top flats.

### C. Volume reduction and contact angle defined line shape

Removal of solvent by evaporation, leading to reduction of the volume of inks, is essential for generating solid entities forming conductive spots or wires. Typically, the thickness of ink droplets and concentration of nanoparticles is high enough that closed films can form. In capillaries, where the volume is given by the height of the groove, the resulting height is in the range of the volume ratio of nanoparticles to solvent. In case of spincoating on V-grooves, the lateral size reduction of the wetted area during evaporation will lead to accumulation of nanoparticles at the bottom of the groove. In comparison to capillary assisted particle assembly (CAPA), which is used for the parallel assembly of sub-micron particles into hexagonal arrangements by convective or capillary effects, inks with its polydisperse distribution of particle sizes typically do not self-assemble, but rather form a loose agglomeration. Instead of the hexagonally packed 500 nm polystyrene (PS) nanoparticles assembled on the surface of a PDMS (Sylgard 184 - Dow Corning) stamp treated with oxygen plasma, particles between 10 and 50 nm form a loose 3D cluster. During volume reduction and concentration it is important that the shrinking ink does not deposit nanoparticles on the dewetted surfaces while the contact line is redrawing. This is different from CAPA where particles assemble along the contact line, thus forming the hexagonal pattern of equal particles.

### Surface energy keeps liquid confined

Solvent evaporation reduces the volume of the ink (e.g. the lateral width of lines) and keeps uncoated areas (e.g. top flats or upper rims of grooves) free from from contamination de-wetted. Areas which have been wetted, will be dewetted. The nanoparticles coalesce and merge, but should leave the dewetted areas free from particles (due to the Maragoni effect). Typically, after inking, the surface is heated. Both, evaporation and sintering may start already at ambient temperature, but may be greatly enhanced by temperature, i.e., to accelerate evaporation of solvent, but also to start the sintering process. The processes may also have a pronounced threshold. This is particularly the case if a substrate reflow is taking place, for which glass transition temperature Tg is defined.

### D. Sintering

Sintering is a process of compacting and forming a solid mass of material by heat or pressure without melting it to the point of liquefaction) are converted into an entity different from the original assembly. The process is temperature dependent, and for flexible electronics moderate low temperature up to 150°C is considered as sufficient to achieve wires with high conductance. Sintering involves nanoparticle growth, but also shape freezing. I.e., the area covered by the nanoparticle cluster will be converted into a solid film, which in case of capillaries is at the surfaces, and in case of dewetting, concentrated at the bottom of the grooves. Therefore, as long as the initial shape of the V- or U-groove is preserved, the capillary is left "open" for further capillary fillings.

### E. Thermal reflow

Thermal reflow uses the surface equilibration and surface energy reduction of viscoelastic materials at temperatures where these materials can flow. Two major regimes: low temperature, i.e. near the glass transition temperature (T_{g}) where viscous flow is considered more a creeping than flow, and high temperature flow, where the polymer behaves as viscous material. In the first case, intermediate states may be created by stopping the flow at a point advantageous for further processing. Here, simultaneous reflow and drying and shrinking of ink. During drying, the solvent will evaporate, the ink particles will coagulate/coalesce and finally form a dense network and sinter together.

The goal to be achieved is here that no or only few further deformation of lines, but flattening of U-grooves, V-grooves occurs. A further confinement of the particle lines during combined drying-sintering-reflow phase can be achieved.

### F. Possible variants

Double reflow: As long as the initial surface pattern is preserved due to volume reduction and dewetting, further coatings with the same material, as well as other materials, can be performed either before the sintering or afterwards. I.e., one line fills over the other one, or the first layer is concentrating on the bottom of the groove while the second layer is covering the first structure; or the first coating is wetting the entire groove sidewalls and the second coating is concentrating in the groove. This can lead to homogeneously layered structures, as needed for electronic devices where conductors and insulators have to be placed on top of each other, or to heterogeneous patterns where one pattern is on top of another pattern with different functionalities.;

Applications for double filling:
TFT transistors with double layer made from electrode material (e.g. nanoparticle silver loaded solved/ink), insulator (Al₂O₃, SiO₂, Si₃N₄) and semiconductor (e.g. ZnO, TiO₂) ;
Wire grid polarizers with sub-wavelength period metal gratings with low area fill factor / variable line width.

The big advantage of the capillary fillings is that capillary forces are used to confine and guide the ink. Due to the use of open capillaries, flow is guided by surface effects rather than pressure (which can be done for closed capillaries). Apart from capillaries or channels, where the liquid is confined by two, three or four interfaces (in square cross section geometry), surface patterns may enhance or inhibit flow. One example is the so-called "Lotus" (superhydrophobic) effect: surface patterns and chemistry is used to manipulate wetting behavior, with a range of possible types, e.g., wetting, de-wetting, roll-off.

Post-processing of inks into metal structures: As has been said before, after spreading and merging of ink droplets, the solvent of inks has to be removed (by soaking into paper substrates or by evaporation in the case of non-dissolving substrates), which is typically done by heat, either by resistive heating or by UV-enhanced exposure. Additional to the drying, ink particles connect and sinter together, thus leading to conductive wires. Flash light annealing (FLA) can be also applied, i.e. short pulses of light which heat the ink but not the substrate, where the heat is quickly dissipated. While heat processes are primarily used to generate functional metal structures, there are additional processes which can be initiated by heat and allow enhancing or even modifying the effect of structural formation of the wires.

Selective thermal reflow: Post-processing of surfaces often involves a local modification of the entire or a part of a specimen. In case of electron beam lithography (EBL) the reduction of molecular weight (e.g. in PMMA) also results in a reduction of *T*_{g}*.* Similar processes have been demonstrated with X-rays. In general, the effects of treatment of polymers by exposure to electrons, photons (X-ray, EUV, DUV, VUV) and ions (plasma) are used for topological and chemical surface modification, i.e. the creation of surface roughness, cleaning from organic components, hardening by crosslinking, enhancement of surface wetting etc.

The "probes" differ in their physical and chemical interaction with the polymer surfaces, but mostly in their surface sensitivity and penetration depth. However, all these processes mentioned above do not only change single material parameters (hardness, solubility, glass transition temperature), or topographies such as surface roughness, but change many parameters at the same time. In the presence of oxygen small hydrocarbon chains may be converted into volatile components and thus surfaces are severely damaged. Therefore, often a balance between damage of the polymer and the desired surface property has to be found, or processing schemes have to be chosen in which the desired property can be modified within a size range (e.g. depth) in which damage is still not detrimental to further processing. For micro-elements, it is still a challenge to connect the vast knowledge about degradation with different probes and processes with micro- and nanofabrication methods.

As said before, two main variants of the process are disclosed:
1. Capillary filling of trenches and grooves by located inking of a reservoir connected to them.
   The aim achieved herewith is to drag ink either directly from droplets deposited on the grooves or on adjacent reservoirs into grooves. Such grooves, typically (but not exclusively) U-shaped (i.e., box-type with vertical sidewalls, flat surface and flat bottom with sharp (90°) or rounded corners), trapezoid (like box-type, but with inclined sidewalls) and V-groove shapes (inclined sidewalls, no or negligible flat at bottom). Typically, when depositing ink on flat surfaces, it assumes a droplet with a contact angle defined by surface energy. Spreading of the droplet or retraction helps to assume the ideal shape. On patterned surfaces (e.g. line-like trenches, pillars or holes), wetting is often first heterogeneous (Cassie-Baxter state), i.e. only on the "tips" or "flats" of the surfaces. In the so-called Wenzel state enables a homogeneous wetting of all surfaces, i.e. also within the grooves. Surface structures enable pinning and therefore the inhibition of spreading, while long trenches/grooves serve as rails for the spreading of the droplet. For line structures, the contact angles forming along grooves and perpendicular to grooves can be different. Additional to the droplet formation, material within the grooves may advance further, simply by capillary action. They are considered as feet, extension or pods going beyond the droplet's extension. They will extend until the end of the groove, when meeting obstacles, when beginning to dry out, or simply when a balance of surface energies is reached and the droplet cannot provide further material without losing its energetically favorable shape. This process has therefore three main features:
   a) Droplets form on structures and assume a specific shape given by the structures and their surface energy. On line structures, this is typically an extended droplet, which is confined along the lines because it cannot jump to the next line while being pinned.
   b) Extensions in the grooves are governed by capillary filling, either by wetting three surfaces and forming a meniscus, or by wetting the corners of the grooves where two walls are meeting. The liquid can drag along the trenches while wetting surface walls.
   c) The liquid may either stop ("starve") at a specific length or merge with other lanes of ink, thus forming a network, in which the droplets (or reservoirs) act as connector pads, and the wires as electrodes. The first structure may be used to generate interdigitated electrodes, the second to generate resistive wires between pads. Important is to note that while the wire width is given by the width of the channels, the distance may vary according to the pre-structuring of the substrate. As long as the ink cannot flow onto the top (i.e., the flats between two channels), the insulation should be perfect.
2. Filling of trenches and grooves by spincoating an entire patterned surface with ink and separation of individual, wire- or dot-like wells by dewetting top-flats or by sharp blade-like separations.
   The aim is to generate individual wires by a "global" process which homogeneously fills all trenches or grooves by spincoating or inking. Due to control of the thickness by spincoating (removal of excess material) or by inking a specific amount of material, the material can fill all grooves up to the rim but will not wet the top of the intersections between two adjacent grooves. In case that the intersection is a sharp ridge, this will allow for separation of the individual ink lines or droplets. This process has therefore three main features:
   a) The spincoating covers the entire surface with liquid material, which is covering all grooves. The rotation will remove excess material from above the grooves and the sharp ridges will act as separation of individual ink lines or droplets. Due to the "V" shape of the grooves, contact angles can be chosen which allow a convex filling of the groove which ridges entirely dewetted and free of ink. Droplets on structures assume a specific shape given by the shape of the structures and their surface energy. The process can be made self-limiting in a way that the amount of ink is defined by the volume of the open trenches.
   b) Upon evaporation of the solvent, the liquid will retract into the grooves, and in best of cases, without leaving any nanoparticles contaminating the dewetted surface. Upon complete evaporation of the solvent, the nanoparticles will collect at the bottom of the groove. The higher the ratio of solvent/nanoparticles is, the more the forming wires (or dots) will shrink and reduce in width. This process can be enhanced by heat treatment, which eventually will merge the nanoparticles and sinter them together to solid entities.
   c) Since the final structure is on the bottom of the grooves, it would be advantageous to remove the V-groove structures. For this a thermal reflow is a suitable process. Upon curing of the ink (at about 150°C), the underlying material (e.g., a polymethyl methacrylate, PMMA) can be softened and due to energy minimization may assume a surface shape in which the ridges sink and the V-grooves become rounded. Since the ink material is first liquid, and then becomes more viscous and finally hard, while shrinking in dimension, it is a simultaneous process. Therefore the V-grooves can be eliminated mostly in regions where there is no coverage with ink, and a thin wire is forming at a small groove which is surrounded by a flattened-out surface. Such a process can be individually addressed by modifying the Tg of the polymeric material.
3. Process 1) and 2) can be combined by using localized coating with ink and capillary filling. By using V-groove shaped channels/capillaries, the lines formed either under the droplets or during capillary filling can then be shrunk by the process described in 2).

At Paul Scherrer Institut, both processes have been successfully demonstrated.

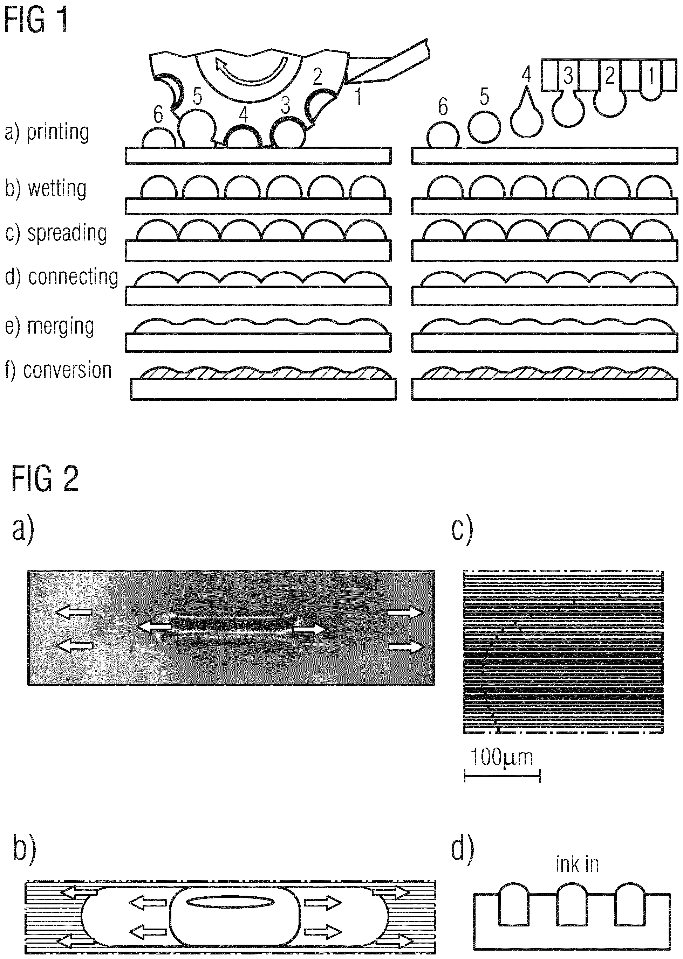

Figure 1 schematically shows a comparison of two major methods used for the fabrication of flexible electronics. Both rely on transfer of individual droplets onto surfaces which merge into a film or a confined pattern (if wires are needed). On the left side gravure printing is illustrated: ink transfer from wells onto a substrate is achieved by intimate contact and balance of ink adhesion on the wells and the substrate. On the right side inkjet printing is illustrated: droplet formation by nozzles and formation of well-shaped droplets which impact on the surface.

Figure 2 schematically illustrates the spreading of ink droplets in pre-patterned substrates: (a) is a photography of an ink droplet being disposed on a fine line pattern; (b) shows a schematic of an elongated droplet with the central part representing the original area of the droplet and the outer parts the extension of the end of the filled capillaries. The period of the line pattern is 10 µm, the width 5 µm and the depth 2 µm; c) illustrates in magnification the end of the line pattern filled with the ink due to the capillary filling of the lines; and d) shows schematically a cross section of the ink filling.

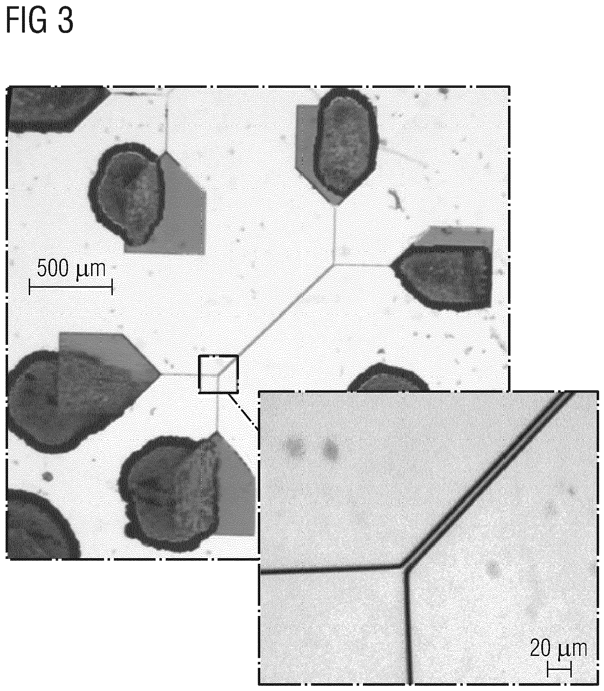

Figure 3 depicts an optical micrograph of a 2 mm long double line filled with silver after filling two trenches from two sides each. The droplets were placed on four pads serving as reservoirs for capillary filling. Magnification shows that 2 and 5 µm wide trenches with 2 and 5 µm distance can be filled to a total length of 2 mm and electrical connection can be achieved by merging. Resistance was measured to be R_{2µm} = 87 Ω and R_{5µm} = 37 Ω for an estimated Ag thickness of 300 nm.

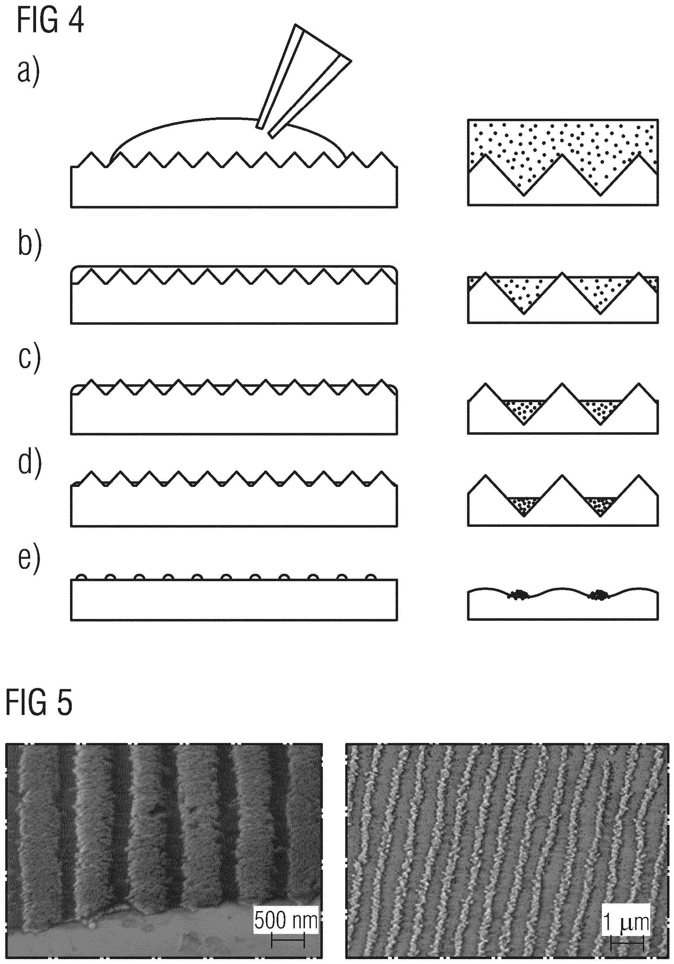

Figure 4 schematically illustrates the process to generate self-forming metal line pattern, left side: general view, right side: magnification. Part (a) illustrated the dispensing of a silver ink on dense V-grooves which are patterned into a substrate, part (b) represents the spin-coating of the ink and the starting of the evaporation of the solvent comprised in the silver ink. Part (c) illustrated schematically the volumetric shrinkage due to drying, part (d) is the densification and the start of the merging of the silver nanoparticles comprised in the silver ink and part (e) shows the simultaneous annealing of silver metal lines and the thermal reflow of the substrate. In particular, the step of the thermal reflow by the application of moderate heat to the substrate which usually comprise thermoplastic polymers substantially contributes to the shrinking of the metal structures stemming from the metallic particle and/or metallic content load in the ink, here silver particles in a silver ink.

Figure 5 depicts SEM micrographs of a self-forming metal line pattern after spin-coating of the silver ink on dense V-grooves with a 830 nm period. The left side shows 600 nm wide wires, the right side 250 nm wide wires. The different line widths were achieved by the variation of the solvent and the dilution ratio. The quality of the lines is mostly dependent on the density of the ink (particle content) and the chosen solvent, which enables to control the evaporation and the ability of the ink to wet and transport the nanoparticles. Further, the geometry and the chemistry of the substrate are of relevance, too.

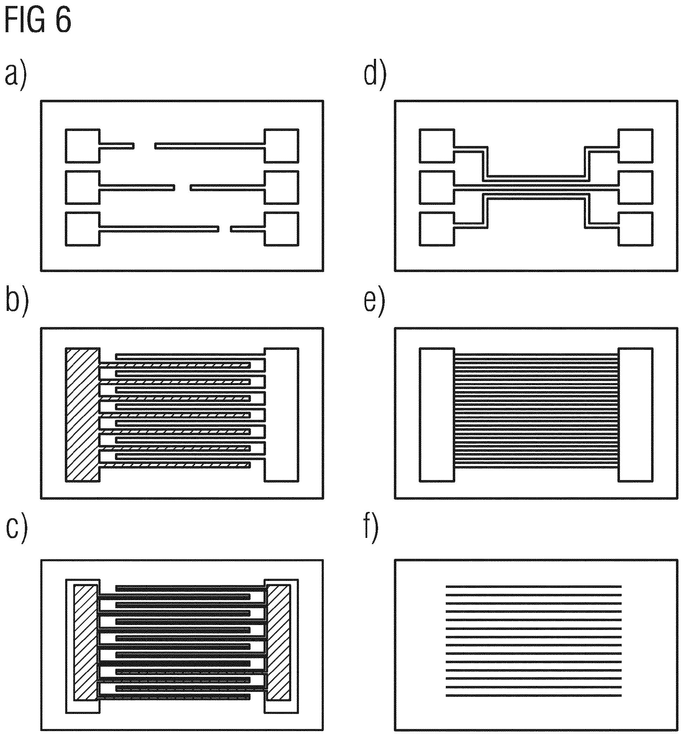

Figure 6 schematically shows of different wire configurations that can be achieved by the application of disclosed methods:
Fig. 6a shows wires attached to pads, b) an interdigitated electrode array with two alternating materials, c) two materials on top of each other, d) wires merged from two pads, e) wire grid between two pads with wide wires and f) narrow wires without pads.

The proposed fabrication methods for the grooves that used for capillary filling or filling by coating are one or more of the following:
- Etching, photolithography, two-photon polymerization, direct writing (i.e. laser, electron beam, and/or focused ion beam), electron beam lithography, etc.;
- Spincoated films, non-supported films, release from surface, sacrificial layers (selective etching);
- embedded design, also applicable if one or two sides are attached to the support substrate or covered by the same or another support substrate;
- Moulding, incl. vertical sidewalls and/or draft angle and/or thickness variations;
- Made from block copolymers such as blocks with different refractive indices and/or different etching behaviour;
- Made from grafting from patterned substrates (directed growth of polymer brushes)
- Extruded through nozzles with the shape of the waveguide cross-section;
- Mechanical removal by scribing (combined cutting and moulding)
- Also if one or two sides (the smaller ones are attached to a substrate or covered by another substrate) - embedded design
- Molding: vertical sidewalls, draft angle, thickness variation;

Suitable Materials for the substrates comprise: polymers, doped polymers, sol-gels, insulators, and any coated version of such materials (i.e. metallic or electrically insulating coatings)

Examples for the application of the micro and nanowires are the following:
Open microfluidics (i.e. fluidics with open capillaries)
   - Electrical wires
   - Interdigitated electrode arrays
   - TFT displays
   - Wire grid polarizers
   - Focusing elements
   - Bio-sensors
V-groove filling and line size reduction
   - Electrical wires for resistive heating and sensing
   - Interdigitated electrode arrays for sensing
   - TFT displays
   - Wire grid polarizers
   - Optical focusing element
   - Bio-sensors
   - Batteries
   - Catalytic surface structures
   - Transparent heating elements

Further application are the printing of metallic or non-metallic materials on flat or non-flat (spherical, aspherical, free-form, convex/concave) surfaces (e.g. displays or ophthalmic lenses), such as heatable lenses by resistive heating. Further applications are the printing of metallic or non-metallic materials on paper, polymer films, e.g., used as security tags / holograms / optical versatile devices (OVD) / diffractive optical elements (DOE). Furthermore, a transfer of structures and/or a film on paper / banknotes / credit cards can be achieved.

## Claims

1. A method for producing insulating and/or electrically conductive micro- and nano-structures, such as wires or an array thereof, on surfaces of a pre-patterned substrate, comprising the steps of:
a) providing the substrate having a surface topography with a patterned structure of grooves and/or capillaries;
b) self-limiting filling of open grooves and/or capillaries with a functional liquid by capillary action; each wire having a width created by the shape and geometry of the open grooves and/or capillaries; said grooves and/or capillaries having dimensions that they are filled by the functional liquid which is dragged into them by capillary action;
c) said grooves and/or capillaries providing lateral confinement of the liquid enabling a separation from neighboring areas and grooves and/or capillaries;
d) said functional liquid comprising a solvent or a mixture of solvents and dispersed particles therein; said particles are significantly smaller than the open width of the grooves and/or capillaries;
e) said particles cluster together upon evaporation of the solvent resulting in structures of clustered particles, such as lines, along the grooves and/or capillaries.

2. The method according to claim 1 wherein a reduction of the width of the filled grooves and/or capillaries is achieved by solvent evaporation and retraction of remaining functional liquid in said grooves and/or capillaries of a pre-patterned surface of the substrate.

3. The method according to claim 1 or 2, wherein locally chemically modified substrates are provided, preferably comprising stripes with alternating surface energies, e.g. hydrophilic and hydrophobic, or grooves with different surface energy than the areas between grooves.

4. The method according to any of the preceding claims, wherein a combination of capillary action and size reduction by solvent evaporation is applied.

5. The method according to any of the preceding claims, wherein the size reduction is supported by heating the substrate after the filling to the extent that a thermal reflow of the substrate occurs; said thermal reflow generating a surface equilibration and surface energy reduction of viscoelastic materials at temperatures where these materials flow.

6. The method according to any of the preceding claims, wherein the functional liquid comprises at least one micro and/or nanoparticle loaded solvent.

7. The method according to claim 6, wherein the ratio of the particle content to the solvent content is varied over the filling step.

8. The method according to claim 6 or 7, wherein the content of the micro- and/or nano-particle load is varied over the filling step.

9. The method according to any of the preceeding claims, wherein the particle load comprise one or more the following ingredients:
i) metals, such as Ag, Au, Co, Pt;
ii) semiconductors, such as Si, GaN, GaAs, TiO₂, ZnO, CdS;
iii) insulators, such as SiO₂, Si₃N₄, Al₂O₃, SiC; and
iv) organic particles, such as bucky balls, polystyrene, PMMA, micelles, diamond, graphite.

10. The method according to any of the preceeding claims, wherein wire structures with a multitude of materials are generated, e.g. by filling different channels with different functional liquids; and/or by filling a trench first with one functional liquid, and then, optionally after drying, with a second material.

11. The method according to claim 10, wherein the first functional liquid assumes a shape in the groove and/or the trench which allows to fill the groove and/or trench either again with the same principle, e.g., capillary filling one material above each other, and/or by a combination, e.g. first V-groove filling, then capillary filling), preferably used for the manufacturing of transistors and/or batteries.

12. The method according to any of the preceding claims, wherein the resulting micro- and/or nano-structures having a ratio of the micro- and/or nano-structures to the width of the grooves and/or capillaries of at least 1:2; preferably achieved by:
a) the solvent evaporation and/or the nanoparticles assembly; and/or
b) the geometry of the grooves and/or capillaries enabling the collection of material by capillary action; e.g. in a V-groove shape (as given by <100> silicon anisotropically etched in KOH), allowing the nanoparticles to segregate and agglomerate in the center of the V-groove.

13. The method according to any of the preceding claims, wherein a generated electrical micro- and nanowire having at least one dimension other than its propagation dimension being smaller than a coupled light wavelength.

14. The method according to any of the preceding claims wherein the assembled (nano-)particles are sintered together to achieve high conductivity structures, wherein the structure generated being disposed according to at least one of the following design options: array-like, ordered, regular and disordered, semi-random, random, variable period or thickness as an array of structures, such as nanowires.
